(19) Europäisches Patentamt

European Patent Office

Office européen des brevets

(11) **EP 0 640 912 B1**

(12) **EUROPEAN PATENT SPECIFICATION**

(45) Date of publication and mention
of the grant of the patent:
**10.05.2000 Bulletin 2000/19**

(51) Int. Cl.[7]: **G06F 9/355**

(21) Application number: **94306378.4**

(22) Date of filing: **30.08.1994**

(54) **Memory addressing scheme for increasing the number of memory locations available in a computer for storing higher precision numbers**

Speicheradressierungsschema zur Erhöhung der Anzahl von Speicherplätzen in einem Rechner zur Speicherung von Doppelgenauigkeitszahlen

Schéma d'adressage de mémoire pour augmenter le nombre de positions de mémoire dans un calculateur pour l'emmagasinage de nombres à précision double

(84) Designated Contracting States:
**DE FR GB NL SE**

(30) Priority: **31.08.1993 US 114466**

(43) Date of publication of application:
**01.03.1995 Bulletin 1995/09**

(73) Proprietor:
**SUN MICROSYSTEMS, INC.
Mountain View, CA 94043 (US)**

(72) Inventors:
• **Cmelik, Robert
Sunnyvale, California 94086 (US)**
• **Kong, Shing
Menlo Park, California 94025 (US)**

• **Kelly, Edmund
San Jose, California 95136 (US)**

(74) Representative:
**Wombwell, Francis et al
Potts, Kerr & Co.
15, Hamilton Square
Birkenhead Merseyside L41 6BR (GB)**

(56) References cited:
**EP-A- 0 483 967          FR-A- 2 428 871
US-A- 3 553 653**

• **IBM TECHNICAL DISCLOSURE BULLETIN. vol.
16, no. 3 , August 1973 , NEW YORK US pages
771 - 772 K. W. STEVENS 'Addressing a Second
Page of Registers Without Increasing the
Register Field Length'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

**BACKGROUND OF THE INVENTION**

1. **FIELD OF THE INVENTION:**

This invention relates to the field of data processing and, more particularly, to addressing memory locations in a computer system to use the address space more effectively when storing higher precision numbers.

2. **ART BACKGROUND:**

Processors execute instructions which perform operations on source operands to obtain a result. The registers that contain the source operands and the destination register for the result are specified in address fields of the instruction word. For example, in a computer based on a scalable processor architecture (SPARC) designed by Sun Microsystems, Inc., the assignee of the present invention, floating point instructions specify up to two floating point source registers and may specify a floating point destination register.

The number of registers available for addressing and the size of the operands used in a particular calculation depend upon the precision required in the result. In the SPARC Version 8 architecture, the floating point processor includes 32 individual registers, each capable of holding the 32 bits of one single precision operand. To obtain more precision in its arithmetic manipulations, a floating point processor may use the 32 registers in pairs to store 16 double precision numbers or in quadruples to hold 8 quadruple precision numbers.

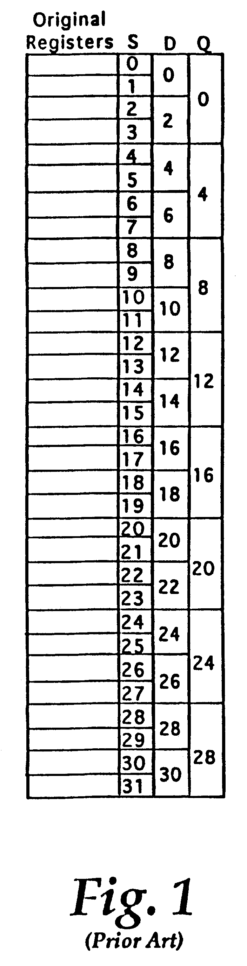

**Figure 1** illustrates the addressing of the SPARC Version 8 register file in this manner. In this example, a double precision operand has 64 bit positions and is held in two aligned floating point registers. Thus, one double precision number may be stored in register 0 and 1, another in registers 2 and 3, and so on in pairs. By aligning the registers, only one of the two registers need be addressed to select a particular double precision floating point number. In a like manner, a quadruple precision operand has 128 bit positions and is held in four aligned floating point registers, e.g., register 0,1, 2 and 3. By aligning the registers only one of the four registers need be addressed to select a particular quadruple precision floating point number, and a similar saving in address bits is accomplished.

Using this aligned register convention, double precision numbers are stored at even numbered register addresses and quadruple precision numbers at every fourth register address. Because the processor only has five-bit instruction address fields, it can only address 16 double precision and 8 quadruple precision numbers using the five bits. Consequently, a number of addresses are unused for both double and quadruple precision arithmetic. The unused addresses designate single position register positions which are conventionally unavailable to the double and quadruple precision operations.

It is desirable to find a way to use these omitted addresses to address additional registers for higher precision numbers, while at the same time remaining compatible with the addressing modes of instruction sets currently in use.

In the Applicant's own earlier patent application, published as EP-A-0483967, there is disclosed an apparatus for increasing the number of registers available in a computer processor comprising a floating point processor including a plurality of registers.

**SUMMARY OF THE INVENTION**

The present invention as set forth in the appended claims provides a backward compatible addressing scheme for increasing the number of memory locations available in a computer for storing higher precision numbers. The computer system of the present invention has a processor capable of manipulating numbers having precision S, where S is a power of 2. The memory locations are specified in an instruction address field by an n-bit logical address

$$E = \sum_{i=0}^{n-1} e_i 2^i.$$

Each S-precision number is stored in a group of S memory locations accessed by an m-bit physical address

$$D = \sum_{i=0}^{m-1} d_i 2^i,$$

Each memory location is capable of storing a single precision number. Addressing logic for addressing the memory locations with the logical addresses includes alignment logic for setting:

$$d_i = 0 \quad 0 \le i \le (\log_2 S)-1,$$

and setting

$$d_i = e_i \quad \log_2 S \le i \le n-1;$$

and extension logic for setting

$$d_i = e_{i-n} \quad n \le i \le m-1$$

The alignment logic may be implemented according to the logic equations

$$d_i = e_i \sum_{j=0}^{i} s_j \quad 0 \le i < k,$$

$$d_i = e_i \quad k \le i < n$$

where k is the number of precision sizes capable of being manipulated by the processor and

$$S = e_i \sum_{i=0}^{k-1} s_i 2^i .$$

The extension logic may be implemented according to the logic equation

$$d_i = e_{i-n} \sum_{j=i-n+1}^{k-1} s_j \quad n \le i \le n+k-2, i < m.$$

The memory locations may typically be microprocessor registers.

## BRIEF DESCRIPTION OF THE DRAWINGS

The objects, features and advantages of the present invention will be apparent to one skilled in the art in light of the following detailed description in which:

**FIGURE 1** illustrates a prior art address mapping scheme.

**FIGURE 2** illustrates the instruction format used by an embodiment of the present invention.

**FIGURE 3** is a block diagram of a microprocessor.

**FIGURE 4** illustrates conventional addressing logic.

**FIGURE 5** illustrates a potential address mapping solution utilizing all five bits of the address field.

**FIGURE 6** illustrates a memory address mapping according to the present invention.

**FIGURE 7** illustrates an embodiment of the addressing logic of the present invention.

**FIGURE 8** is a flowchart diagramming the process of the present invention.

## NOTATION AND NOMENCLATURE

Some portions of the detailed descriptions which follow are presented in terms of algorithms and symbolic representations of operations on bits within a computer memory. These algorithmic descriptions and representations are the means used by those skilled in the data processing arts to most effectively convey the substance of their work to others skilled in the art. An algorithm is here, and generally, conceived to be a self-consistent sequence of steps leading to a desired result. The steps are those requiring physical manipulations of physical quantities. Usually, though not necessarily, these quantities take the form of electrical or magnetic signals capable of being stored, transferred, combined, compared, and otherwise manipulated. It has proven convenient at times, principally for reasons of common usage, to refer to these signals as bits, values, elements, symbols, characters, terms, numbers, or the like. It should be borne in mind, however, that all of these and similar terms are to be associated with the appropriate physical quantities and are merely convenient labels applied to these quantities.

Further, the manipulations performed are often referred to in terms, such as adding or comparing, which are commonly associated with mental operations performed by a human operator. No such capability of a human operator is necessary or desirable in most cases in any of the operations described herein which form part of the present invention; the operations are machine operations. Useful machines for performing the operations of the present invention include general purpose digital computers or other similar devices. In all cases the distinction between the method operations in operating a computer and the method of computation itself should be borne in mind. The present invention relates to apparatus for operating a computer in processing electrical or other (e.g. mechanical, chemical) physical signals to generate other desired physical signals.

## DETAILED DESCRIPTION OF THE INVENTION

The present invention provides a backward compatible addressing scheme for increasing the number of memory locations available in a computer for storing higher precision numbers. For purposes of explanation, specific embodiments are set forth to provide a thorough understanding of the present invention. However, it will be apparent to one skilled in the art that the invention may be practiced without these details. In other instances, well known elements, devices, process steps and the like are not set forth in detail in order to avoid unnecessarily obscuring the present invention.

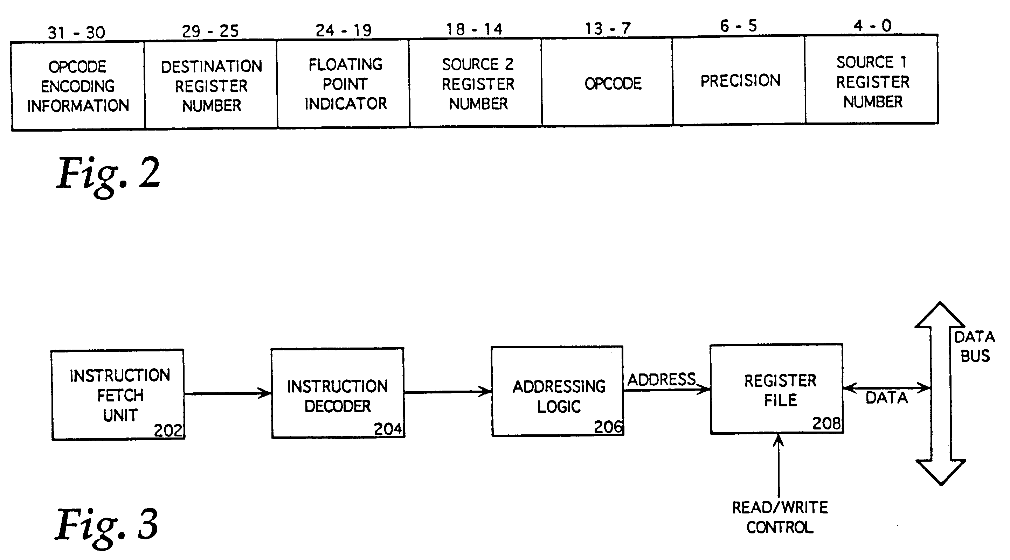

**Figure 2** illustrates the instruction format used by an embodiment of the present invention. Bits 7 through 13 specify the opcode of the instruction, bits 0 through 4 and 14 through 18 are the five bit addresses of the source 1 and source 2 registers, respectively, and bits 25 through 29 are the five bit destination register address. In addition, bits 5 and 6 designate whether the instruction is single precision, double precision or quadruple precision.

**Figure 3** is a simplified block diagram of a microprocessor. Instruction fetch unit 202 fetches instructions from memory. The instructions are decoded by instruction decoder 204, which provides the address as specified by the instruction to addressing logic 206. Addressing logic 206 converts the instruction register addresses into a form used to access the physical registers of the register file 208. The addresses are used to read from the source 1 and source 2 registers and to write to the destination register in the register file 208. The precision specified by bits 5 and 6 of the instruction determine the number of registers addressed by each address. That is, a single precision instruction operates using one register, a double precision instruction operates on pairs of registers, and a quadruple precision instruction accesses four registers at a time.

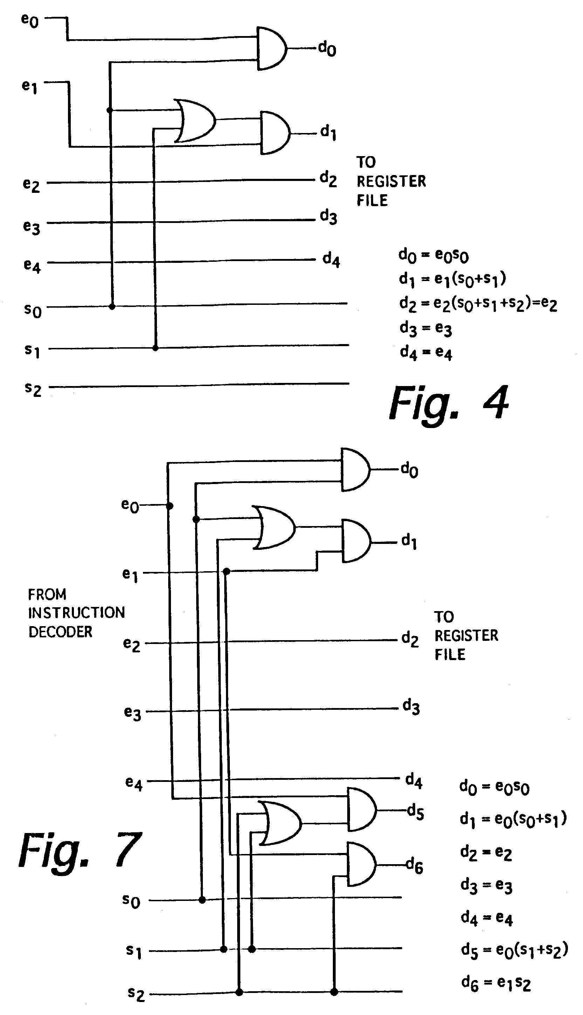

**Figure 4** illustrates conventional addressing logic 206 (found in SPARC Version 8)that maps the logical addresses specified in the instruction to the physical addresses used by the register file 208. The physical memory address D is a function of the logical address E and the precision S. To comply with memory alignment requirements, the logical memory addresses in this prior art system must be an integer multiple of the precision, where the precision is a power of 2. The logical memory address E of the instruction may be represented by the logic equation:

$$E = \sum_{i=0}^{n-1} e_i 2^i,$$

and the physical address D presented to the register:

$$D = \sum_{i=0}^{m-1} d_i 2^i.$$

The precision S may be represented by:

$$S = \sum_{i=0}^{k-1} s_i 2^i,$$

where only one of the k values $s_i$ in the binary representation for S will be one because S is a power of 2.

To produce the physical address from the logical address and the precision, the functions performed by conventional addressing logic may be summarized by the following logic equations, which are basically a restatement of the alignment requirement:

$$d_i = e_i \sum_{j=0}^{i} s_j \quad 0 \le i < k$$

$$d_i = e_i \qquad k \le i < n = m$$

Note that in the prior art the number of bits in the physical address m must equal the number of bits in the logical address n. The memory alignment requirements limit the number uniquely accessible memory regions to $2^{n-S+1}$. For example, in the case of the Version 8 SPARC architecture floating point register file, 32 single precision floating point registers may be accessed, while only 16 double-size registers and 8 quad-size registers may be accessed. For the case of n=m=5 bits, the equations produce the following mapping:

| i | $e_i$ | $d_i$ | | |
|---|---|---|---|---|
| | | Single Precision | Double Precision | Quadruple Precision |
| 0 | $e_0$ | $e_0$ | 0 | 0 |
| 1 | $e_1$ | $e_1$ | $e_1$ | 0 |
| 2 | $e_2$ | $e_2$ | $e_2$ | $e_2$ |
| 3 | $e_3$ | $e_3$ | $e_3$ | $e_3$ |
| 4 | $e_4$ | $e_4$ | $e_4$ | $e_4$ |
| Range (E) | | (0,1,2,...,31) | (0,2,4,...,30) | (0,4,8,...,28) |

The chart illustrates that the least significant bit of a double word register address specifier is reserved and set to 0, and the least significant two bits of a quadword register address are set to 0. This insures that double words in the register file are addressed in aligned pairs and quad words in aligned groups of 4.

The conventional addressing scheme limits the number of double and quadruple precision numbers that may be addressed using 5 bits. It is desirable to achieve more effective use of all 5 bits of the logical address so that a full set of 32 double and quadruple precision register sets may be addressed using both the conventional aligned addresses and the omitted addresses. Clearly, for higher precision numbers, instructions could not perform addressing using both the aligned address and the omitted addresses because such a scheme would result in corruption of the data using the current register's configuration.

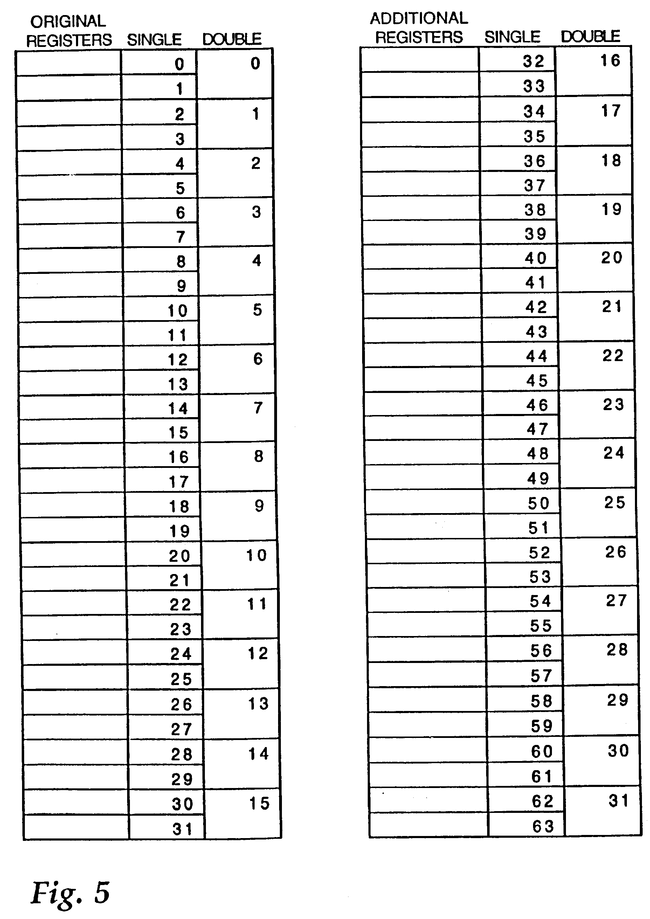

One solution to this problem would be to provide additional sets of registers for each precision to fill up the 5 bit address space, and perform a simple mapping of the form D=SE to address the physical registers. This mapping is shown for double word registers in **Figure 5**. Double word address 0 addresses the register pair beginning with physical address 0, double word address 1 addresses the register pair starting with physical address 2, double word address 2 addresses the register pair beginning with physical address 4, and so on. For quadruple precision addressing, logical address 0 would address physical 0, logical address 1 would address physical address 4, logical address 2 would address physical address 8, and so on.

The problem with this scheme is that it does not satisfy the alignment requirement for the original registers and is thus not backward compatible with the prior art addressing scheme. Present instruction sets are designed so that each higher precision address is the same as the address of the first single precision register in the group of registers corresponding to the higher precision address. Double word address 2 starts at single word address 2, double word address 4 starts at single word address 4, etc., and quad-word address 4 starts at single word address 4, quad-word address 8 starts at single word address 8, etc. in the original register file. One can see from **Figure 5** that this correspondence does not exist for the proposed solution. Accordingly, this scheme would not be compatible with the current design of instruction sets for which much software has been written.

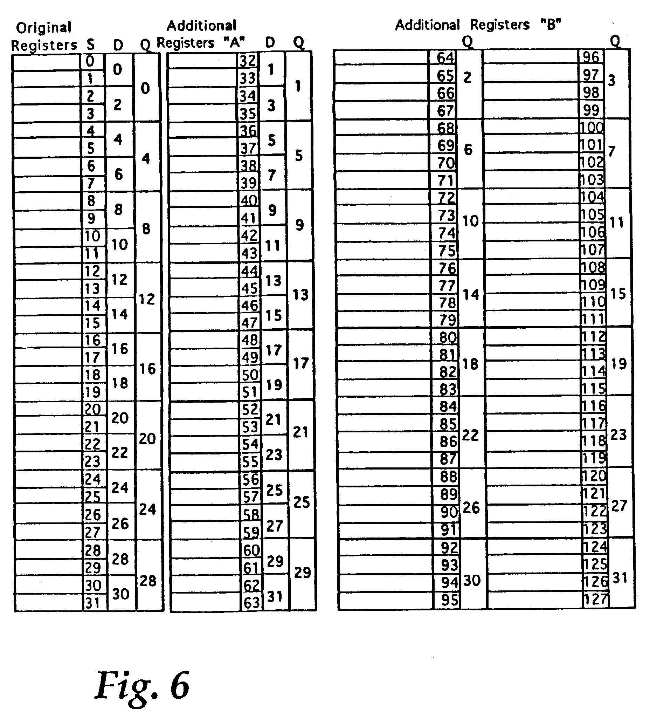

The present invention provides for full utilization of the address space when addressing higher precision numbers as well as compatibility with the existing register addressing scheme. **Figure 6** illustrates memory addressing according to the present invention. Let n equal the number of bits in the logical address E, m the number of bits in the physical address D, and k equal the number of precision sizes available in the instruction set. **Figure 6** illustrates the present invention for the case n=5 (32 original registers), m=7 (128 total registers) and k=3 (single, double and quadruple precision numbers). For the original set of 32 registers, the present invention maintains the same correspondence of the double word and quad word addresses to the physical registers as found in the existing addressing scheme. The present invention further addresses additional registers with the double word and quad word addresses omitted by the prior art. Thus, for example, the odd numbered addresses omitted from the normal addressing scheme for double precision registers are used to address pairs of the additional registers. This allows a full set of 32 double precision registers to be addressed using the 5 bit logical address.

The mapping of the logical address E to the physical address D of the present invention may be summarized by the following logic equations:

$$E = \sum_{i=0}^{n-1} e_i 2^i,$$

$$D = \sum_{i=0}^{m-1} d_i 2^i.$$

$$S = \sum_{i=0}^{k-1} s_i 2^i,$$

where k=the number of precision sizes available to the processor,

$$d_i = e_i \sum_{j=0}^{i} s_j \quad 0 \le i < k$$

$$d_i = e_i \qquad k \le i < n$$

$$d_i = e_{i-n} \sum_{j=i-n+1}^{k-1} s_j \quad n \le i \le n+k-2, \, i < m$$

Using these equations the number of uniquely accessible registers becomes $2^n$ for $S \le 2^{m-n}$.

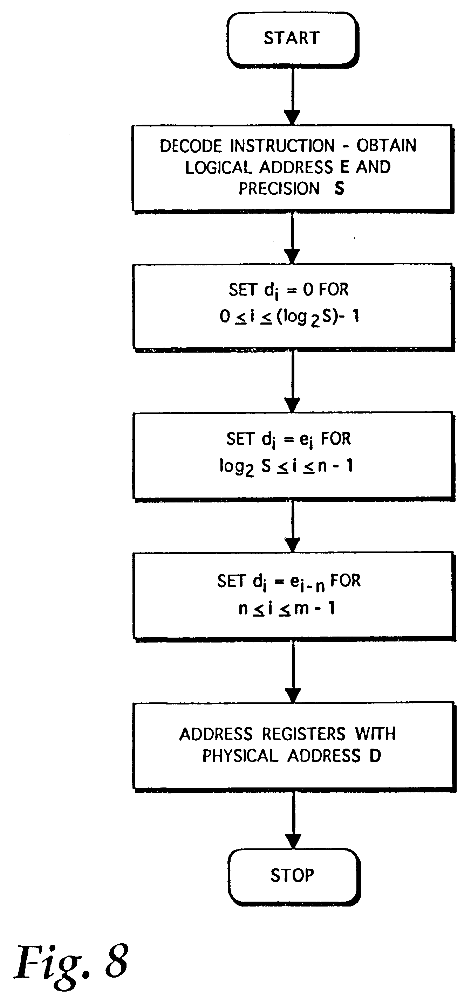

These equations may be implemented using the circuit of **Figure 7** for the case n=5, m=7 and k-3. A flow chart of the method of the present invention is diagrammed in **Figure 8**.

For these parameters, the equations take the form

$$d_0 = e_0 \, s_0$$

$$d_1 = e_1 \, (s_0 + s_1)$$

$$d_2 = e_2 \, (s_0 + s_1 + s_2) = e_2$$

$$d_3 = e_3$$

$$d_4 = e_4$$

$$d_5 = e_0 \, (s_1 + s_2)$$

$$d_6 = e_1 s_2$$

Alternatively, the equations may be expressed as:

$$d_i = 0 \qquad 0 \le i \le (\log_2 S) - 1$$

$$d_i = e_i \qquad \log_2 S \le i \le n-1$$

$$d_i = e_{i-n} \qquad n \le i \le m-1$$

These equations result in the following address mapping.

| i | $e_i$ | $d_i$ | | |
|---|-------|-------------------|------------------|--------------------|
|   |       | Single Precision  | Double Precision | Quadruple Precision |
| 0 | $e_0$ | $e_0$ | 0 | 0 |
| 1 | $e_1$ | $e_1$ | $e_1$ | 0 |
| 2 | $e_2$ | $e_2$ | $e_2$ | $e_2$ |

(continued)

| i | $e_i$ | $d_i$ | | |
|---|---|---|---|---|
| | | Single Precision | Double Precision | Quadruple Precision |
| 3 | $e_3$ | $e_3$ | $e_3$ | $e_3$ |
| 4 | $e_4$ | $e_4$ | $e_4$ | $e_4$ |
| 5 | | 0 | $e_0$ | $e_0$ |
| 6 | | 0 | 0 | $e_1$ |
| Range (E) | | (0,1,2,...,31) | (0,1,2,...,31) | (0,1,2,...,31) |

This table illustrates that the present invention allows the full five bit address space ($e_0$, $e_1$, $e_2$ $e_3$, $e_4$) to be used to address $2^n$ S-precision numbers. At the same time, the physical memory addresses remain aligned to maintain compatibility with conventional addressing schemes.

**Claims**

1.  Addressing logic (206) for addressing memory locations in a computer system having a processor for manipulating a plurality of numbers having precision S, where S is a power of 2, wherein memory locations are specified in an instruction address field by an n-bit logical address

$$E = \sum_{i=0}^{n-1} e_i 2^i,$$

where $e_i$ are logical address binary coefficient signals, each number having precision S is stored in a group of S memory locations accessed by an m-bit physical address

$$D = \sum_{i=0}^{m-1} d_i 2^i,$$

where $d_i$ are physical address binary coefficient signals, each memory location is adapted to store a single precision number, said addressing logic (206) characterised by:

alignment logic for receiving logical address binary coefficient signals and, in response, generating the physical address binary coefficient signals $d_i = 0$ for $0 \le i \le (\log_2 S) - 1$ and $d_i = e_i$ for $\log_2 S \le i \le$ n-1 ; and
extension logic for receiving logical address binary coefficient signals and, in response, generating the physical address binary coefficient signals $d_i = e_{i-n}$ for $n \le i \le$ m-1 ,
wherein the alignment logic and the extension logic share P logical address binary coefficient signals, where P is the number of instances in which i=j where $\log_2 S \le i \le$ n-1 and $0 \le j \le$ m-n-1 .

2.  The addressing logic (206) of claim 1, wherein k is a number of precision sizes of the plurality of numbers having precision S,

$$S = \sum_{i=0}^{k-1} s_i 2^i,$$

where $s_i$ are precision binary coefficient signals, and said alignment logic generates the physical address binary coefficient signals $d_i$ according to the following logic equations:

$$d_i = e_i \sum_{j=0}^{i} s_j \quad 0 < i < k$$

$$d_i = e_i \quad\quad k < i < n$$

3. The addressing logic (206) of claim 1, wherein k is a number of precision sizes of the plurality of numbers having precision S,

$$S = \sum_{i=0}^{k-1} s_i 2^i,$$

where $s_i$ are precision binary coefficient signals, and said extension logic generates the physical address binary coefficient signals di according to the following logic equation:

$$d_i = e_{i-n} \sum_{j=i-n+1}^{k-1} s_j \quad n \le i \le n+k-2, i < m$$

4. The addressing logic (206) of claim 1, wherein said memory locations are microprocessor registers.

5. A method for addressing memory locations in a computer system having a processor for manipulating a plurality of numbers having precision S, where S is a power of 2, wherein memory locations are specified in an instruction address field by an n-bit logical address

$$E = \sum_{i=0}^{n-1} e_i 2^i,$$

where $e_i$ are logical address binary coefficient signals, each number having precision S is stored in a group of S memory locations accessed by an m-bit physical address

$$D = \sum_{i=0}^{m-1} d_i 2^i,$$

where $d_i$ are physical address binary coefficient signals, each memory location is adapted to store a single precision number, said method characterised by the steps of:

(a) receiving logical address binary coefficient signals;
(b) responsive to the received logical address binary coefficient signals, generating the physical address binary coefficient signals $d_i = 0$ for $0 \le i \le (\log_2 S) - 1$ ;
(c) responsive to the received logical address binary coefficient signals, generating the physical address binary

coefficient signals $d_i = e_i$ for $\log_2 S \leq i \leq n-1$ ; and

(d) responsive to the received logical address binary coefficient signals, generating the physical address binary coefficient signals $d_i = e_{i-n}$ for $n \leq i \leq m-1$ .

6. The method of claim 5, wherein k is a number of precision sizes of the plurality of numbers having precision S,

$$S = \sum_{i=0}^{k-1} s_i 2^i,$$

where $s_i$ are precision binary coefficient signals,

step (b) is implemented according to the logic equation:

$$d_i = e_i \sum_{j=0}^{i} s_j \quad 0 < i < k$$

and step (c) is implemented according to the logic equation:

$$d_i = e_i \qquad k < i < n.$$

7. The method of claim 5, wherein k is a number of precision sizes of the plurality of numbers having precision S,

$$S = \sum_{i=0}^{k-1} s_i 2^i,$$

where $s_i$ are precision binary coefficient signals, and step (d) is implemented according to the logic equation:

$$d_i = e_{i-n} \sum_{j=i-n+1}^{k-1} s_j \qquad n < i < n+k-2, i < m$$

8. The method of claim 5, wherein said memory locations are microprocessor registers.

9. A processor for manipulating a plurality of numbers having precision S, where S is a power of 2, the processor having a first plurality of memory locations addressable by a first plurality of logical addresses E, each logical address of the first plurality of logical addresses having the form cS, where c is from the set {0, 1, ..., ((r/S) - 1)}, r being the number of memory locations in the first plurality of memory locations, each memory location in the first plurality of memory locations being capable of storing a single precision number, the memory locations of the first plurality of memory locations being addressable in groups of S, the processor further characterised by:

a plurality of S-1 additional pluralities of memory locations, each memory location in each additional plurality of memory locations being capable of storing a single precision number, the memory locations in each additional plurality of memory locations being addressable in groups of S, r being the number of memory locations in each additional plurality of memory locations; and
addressing logic (206) for addressing the plurality of S-1 additional pluralities of memory locations using an associated additional plurality of logical addresses for each additional plurality of memory locations, each address of an i-th associated additional plurality of logical addresses having the form cS+i where i is from the set {1, 2, ..., S-1}, the addressing logic (206) being coupled to the additional pluralities of registers.

**10.** The processor of claim 9, wherein memory locations are specified in an instruction address field by an n-bit logical address

$$E = \sum_{i=0}^{n-1} e_i 2^i,$$

where $e_i$ are logical address binary coefficient signals, each S-precision number is accessed by an m-bit physical address

$$D = \sum_{i=0}^{m-1} d_i 2^i,$$

where $d_i$ are physical address binary coefficient signals, said addressing logic (206) includes

alignment logic for receiving logical address binary coefficient signals and, in response, generating the physical address binary coefficient signals $d_i = 0$ for $0 \leq i \leq (\log_2 S) - 1$ and $d_i = e_i$ for $\log_2 S \leq i \leq n-1$; and extension logic for receiving logical address binary coefficient signals and, in response, generating the physical address binary coefficient signals $d_i = e_{i-n}$ for $n \leq i \leq m-1$,
wherein the alignment logic and the extension logic share P logical address binary coefficient signals, where P is the number of instances in which i=j where $\log_2 S \leq i \leq n-1$ and $0 \leq j \leq m-n-1$.

**11.** The processor of claim 10, wherein k is a number of precision sizes of the plurality of numbers having precision S,

$$S = \sum_{i=0}^{k-1} s_i 2^i,$$

where $s_i$ are precision binary coefficient signals, and said alignment logic generates the precision address binary coefficient signals $d_i$ according to the following logic equations:

$$d_i = e_i \sum_{j=0}^{i} s_j \quad 0 < i < k$$

$$d_i = e_i \qquad k < i < n$$

**12.** The processor of claim 10, wherein k is a number of precision sizes of the plurality of numbers having precision S,

$$S = \sum_{i=0}^{k-1} s_i 2^i,$$

where $s_i$ are precision binary coefficient signals, and said extension logic generates the precision address binary coefficient signals $d_i$ according to the following logic equation:

$$d_i = e_{i-n} \sum_{j=i-n+1}^{k-1} s_j \quad n \le i \le n+k-2,\ i < m$$

**13.** The processor of claim 10, wherein said memory locations are microprocessor registers.

**Patentansprüche**

**1.** Adressierlogik (206) zum Adressieren von Speicherplätzen in einem Computersystem, das einen Prozessor zum Bearbeiten einer Mehrzahl von Zahlen der Genauigkeit S aufweist, wobei S eine Potenz von 2 ist, wobei die Speicherplätze in einem Befehlsadreßfeld spezifiziert sind durch eine logische n-Bit-Adresse

$$E = \sum_{i=0}^{n-1} e_i 2^i,$$

wobei $e_i$ binäre Koeffizientensignale der logischen Adresse sind, wobei jede Zahl mit der Genauigkeit S in einer Gruppe von S Speicherplätzen gespeichert wird, auf die zugegriffen wird mit einer physikalischen m-Bit-Adresse

$$D = \sum_{i=0}^{m-1} d_i 2^i,$$

wobei $d_i$ binäre Koeffizientensignale der physikalischen Adresse sind, wobei jeder Speicherplatz eine Zahl mit einfacher Genauigkeit speichern kann, wobei die Adressierlogik (206) gekennzeichnet ist durch:

eine Ausrichtungslogik, um binäre Koeffizientensignale der logischen Adresse zu empfangen und als Antwort die binären Koeffizientensignale der physikalischen Adresse $d_i=0$ für $0 \le i \le (\log_2 S)-1$ und $d_i = e_i$ für $\log_2 S \le i \le n-1$ zu erzeugen; und
eine Erweiterungslogik, um binäre Koeffizientensignale der logischen Adresse zu empfangen und als Antwort die binären Koeffizientensignale der physikalischen Adresse $d_i = e_{i-n}$ für $n \le i \le m-1$ zu erzeugen,
wobei die Ausrichtungslogik und die Erweiterungslogik P binäre Koeffizientensignale der logischen Adresse gemeinsam verwenden, wobei P die Zahl der Fälle angibt, in denen $i=j$, wobei $\log_2 S \le i \le n-1$ und $0 \le j \le m-n-1$.

**2.** Adressierlogik (206) nach Anspruch 1, wobei k eine Anzahl von Genauigkeitsstufen der Mehrzahl von Zahlen mit der Genauigkeit S ist,

$$S = \sum_{i=0}^{k-1} s_i 2^i,$$

wobei $s_i$ binäre Koeffizientensignale der Genauigkeit sind, und wobei die Ausrichtungslogik die binären Koeffizientensignale der physikalischen Adresse $d_i$ gemäß den folgenden logischen Gleichungen erzeugt:

$$d_i = e_i \sum_{j=0}^{i} s_j \qquad 0<i<k$$

$$d_i = e_i \qquad k<i<n$$

3. Adressierlogik (206) nach Anspruch 1, wobei k eine Anzahl von Genauigkeitsstufen der Mehrzahl von Zahlen mit der Genauigkeit S ist,

$$S = \sum_{i=0}^{k-1} s_i 2^i,$$

wobei $s_i$ binäre Koeffizientensignale der Genauigkeit sind, und wobei die Erweiterungslogik die binären Koeffizientensignale der physikalischen Adresse $d_i$ gemäß der folgenden logischen Gleichung erzeugt:

$$d_i = e_{i-n} \sum_{j=i-n+1}^{k-1} s_j \qquad n \leq i \leq n+k-2, i<m$$

4. Adressierlogik (206) nach Anspruch 1, wobei die Speicherplätze Mikroprozessorregister sind.

5. Verfahren zum Adressieren von Speicherplätzen in einem Computersystem, das einen Prozessor zum Bearbeiten einer Mehrzahl von Zahlen der Genauigkeit S aufweist, wobei S eine Potenz von 2 ist, wobei die Speicherplätze in einem Befehlsadreßfeld spezifiziert sind durch eine logische n-Bit-Adresse

$$E = \sum_{i=0}^{n-1} e_i 2^i,$$

wobei $e_i$ binäre Koeffizientensignale der logischen Adresse sind, wobei jede Zahl mit der Genauigkeit S in einer Gruppe von S Speicherplätzen gespeichert wird, auf die zugegriffen wird mit einer physikalischen m-Bit-Adresse

$$D = \sum_{i=0}^{m-1} d_i 2^i,$$

wobei $d_i$ binäre Koeffizientensignale der physikalischen Adresse sind, wobei jeder Speicherplatz eine Zahl mit einfacher Genauigkeit speichern kann, wobei das Verfahren gekennzeichnet ist durch die Schritte:

(a) daß binäre Koeffizientensignale der logischen Adresse empfangen werden;
(b) daß als Antwort auf die empfangenen binären Koeffizientensignale der logischen Adresse die binären Koeffizientensignale der physikalischen Adresse $d_i = 0$ für $0 \leq (\log_2 S)-1$ erzeugt werden;
(c) daß als Antwort auf die empfangenen binären Koeffizientensignale der logischen Adresse die binären Koef-

fizientensignale der physikalischen Adresse $d_i = e_{i-n}$ für $\log_2 S \leq i \leq n-1$ erzeugt werden; und

(d) daß als Antwort auf die empfangenen binären Koeffizientensignale der logischen Adresse die binären Koeffizientensignale der physikalischen Adresse $d_i = e_{i-n}$ für $n \leq i \leq m-1$ erzeugt werden.

**6.** Verfahren nach Anspruch 5, wobei k eine Anzahl von Genauigkeitsstufen der Mehrzahl von Zahlen mit Genauigkeit S ist,

$$S = \sum_{i=0}^{k-1} s_i 2^i,$$

wobei $s_i$ binäre Koeffizientensignale der Genauigkeit sind,

wobei Schritt (b) gemäß der logischen Gleichung ausgeführt wird:

$$d_i = e_i \sum_{j=0}^{i} s_j \qquad 0 < i < k$$

und der Schritt (c) gemäß der logischen Gleichung ausgeführt wird:

$$d_i = e_i \qquad k < i < n.$$

**7.** Verfahren nach Anspruch 5, wobei k eine Anzahl von Genauigkeitsstufen der Mehrzahl von Zahlen mit der Genauigkeit S angibt,

$$S = \sum_{i=0}^{k-1} s_i 2^i,$$

wobei $s_i$ binäre Koeffizientensignale der Genauigkeit sind, und der Schritt (d) gemäß der logischen Gleichung ausgeführt wird:

$$d_i = e_{i-n} \sum_{j=i-n+1}^{k-1} s_j \qquad n < i < n+k-2, i < m$$

**8.** Verfahren nach Anspruch 5, wobei die Speicherplätze Mikroprozessorregister sind.

**9.** Prozessor zum Bearbeiten einer Mehrzahl von Zahlen der Genauigkeit S, wobei S eine Potenz von 2 ist, wobei der Prozessor eine erste Mehrzahl von Speicherplätzen aufweist, die mit einer ersten Mehrzahl von logischen Adressen E adressierbar sind, wobei jede logische Adresse der ersten Mehrzahl von logischen Adressen die Form cS hat, wobei c Element der Menge {0, 1, ..., ((r/S)-1)} ist, wobei r die Anzahl der Speicherplätze in der ersten Mehrzahl von Speicherplätzen angibt, wobei jeder Speicherplatz in der ersten Mehrzahl von Speicherplätzen eine Zahl mit einfacher Genauigkeit speichern kann, wobei die Speicherplätze der ersten Mehrzahl von Speicherplätzen in Gruppen von S adressierbar sind, wobei der Prozessor ferner gekennzeichnet ist durch:

eine Mehrzahl von S-1 zusätzlichen Mehrzahlen von Speicherplätzen, wobei jeder Speicherplatz in jeder zusätzlichen Mehrzahl von Speicherplätzen eine Zahl mit einfacher Genauigkeit speichern kann, wobei die Speicherplätze in jeder zusätzlichen Mehrzahl von Speicherplätzen in Gruppen von S adressierbar sind, wobei r die Anzahl der Speicherplätze in jeder zusätzlichen Mehrzahl von Speicherplätzen angibt; und

eine Adressierlogik (206) zum Adressieren der Mehrzahl von S-1 zusätzlichen Mehrzahlen von Speicherplätzen mit Hilfe einer zugehörigen zusätzlichen Mehrzahl von logischen Adressen für jede zusätzliche Mehrzahl von Speicherplätzen, wobei jede Adresse einer zugehörigen i-ten zusätzlichen Mehrzahl von logischen Adressen die Form cS+i hat, wobei i Element der Menge {1, 2, ..., S-1} ist, wobei die Adressierlogik (206) mit den zusätzlichen Mehrzahlen von Registern gekoppelt ist.

10. Prozessor nach Anspruch 9, wobei die Speicherplätze in einem Befehlsadreßfeld spezifiziert sind durch eine logische n-Bit-Adresse

$$E = \sum_{i=0}^{n-1} e_i 2^i,$$

wobei $e_i$ binäre Koeffizientensignale der logischen Adresse sind, wobei auf jede Zahl der Genauigkeit S zugegriffen wird mit einer physikalischen m-Bit-Adresse

$$D = \sum_{i=0}^{m-1} d_i 2^i,$$

wobei $d_i$ binäre Koeffizientensignale der physikalischen Adresse sind, wobei die Adressierlogik (206) aufweist:

eine Ausrichtungslogik, um binäre Koeffizientensignale der logischen Adresse zu empfangen und als Antwort die binären Koeffizientensignale der physikalischen Adresse zu erzeugen $d_i=0$ für $0 \leq i \leq (\log_2 S)-1$ und $d_i=e_i$ für $\log_2 S \leq i \leq n-1$; und
eine Erweiterungslogik, um binäre Koeffizientensignale der logischen Adresse zu empfangen und als Antwort die binären Koeffizientensignale der physikalischen Adresse zu erzeugen $d_i=e_{i-n}$ für $n \leq i \leq m-1$,
wobei die Ausrichtungslogik und die Erweiterungslogik P binäre Koeffizientensignale der logischen Adresse gemeinsam verwenden, wobei P die Anzahl der Fälle ist, in denen $i=j$, wobei $\log_2 S \leq i \leq n-1$ und $0 \leq j \leq m-n-1$.

11. Prozessor nach Anspruch 10, wobei k eine Anzahl von Genauigkeitsstufen der Mehrzahl von Zahlen mit Genauigkeit S ist,

$$S = \sum_{i=0}^{k-1} s_i 2^i,$$

wobei $s_i$ binäre Koeffizientensignale der Genauigkeit sind und wobei die Ausrichtungslogik die binären Koeffizientensignale der physikalischen Adresse $d_i$ gemäß den folgenden logischen Gleichungen erzeugt:

$$d_i = e_i \sum_{j=0}^{i} s_j \qquad 0 < i < k$$

$$d_i = e_i \qquad k < i < n$$

**12.** Prozessor nach Anspruch 10, wobei k eine Anzahl von Genauigkeitsstufen der Mehrzahl von Zahlen mit Genauigkeit S ist,

$$S \ = \ \sum_{i=0}^{k-1} s_i 2^i,$$

wobei $s_i$ binäre Koeffizientensignale der Genauigkeit sind, und wobei die Erweiterungslogik die binären Koeffizientensignale $d_i$ der Genauigkeit gemäß der folgenden logischen Gleichung erzeugt:

$$d_i \ = \ e_{i-n} \sum_{j=i-n+1}^{k-1} s_j \qquad n \leq i \leq n+k-2, i < m$$

**13.** Prozessor nach Anspruch 10, wobei die Speicherplätze Mikroprozessorregister sind.

**Revendications**

**1.** Circuit logique d'adressage (206) pour l'adressage de positions en mémoire dans un système informatique possédant un processeur pour la manipulation d'une pluralité de nombres de précision S, S étant une puissance de 2, dans lequel les positions en mémoire sont spécifiées dans un champ d'adresse d'instruction par une adresse logique de n bits :

$$E = \sum_{i=0}^{n-1} e_i 2^i$$

où $e_i$ sont des signaux de coefficient binaire d'adresse logique, chaque nombre ayant une précision S est stocké dans un groupe de S positions en mémoire accédées par une adresse physique de m bits :

$$D = \sum_{i=0}^{m-1} d_i 2^i$$

où $d_i$ sont des signaux de coefficient binaire d'adresse physique, chaque position en mémoire est prévue pour stocker un nombre de simple précision ;

ledit circuit logique d'adressage (206) étant caractérisé par :

- un circuit logique d'alignement pour recevoir des signaux de coefficient binaire d'adresse logique et pour générer en réponse les signaux de coefficient binaire d'adresse physique $d_i = 0$ pour $0 \leq i \leq (\log_2 S)-1$ et $d_i = e_i$ pour $\log_2 S \leq i \leq n-1$ ; et

- un circuit logique d'extension pour recevoir des signaux de coefficient binaire d'adresse logique et pour générer, en réponse, les signaux de coefficient binaire d'adresse physique $d_i = e_{i-n}$ pour $n \leq i \leq m-1$ ;

dans lequel le circuit logique d'alignement et le circuit logique d'extension partagent P signaux de coefficient binaire d'adresse logique, P étant le nombre de cas pour lesquels $i = j$ avec $\log_2 S \leq i \leq n-1$ et $0 \leq j \leq m-n-1$.

**2.** Circuit logique d'adressage (206) selon la revendication 1, dans lequel k est un nombre de précisions de la pluralité de nombres ayant une précision S avec

$$S = \sum_{i=0}^{k-1} e_i 2^i$$

où si sont des signaux de coefficient binaire de précision, et ledit circuit logique d'alignement génère les signaux de coefficient binaire d'adresse physique $d_i$ selon les équations logiques suivantes :

$$d_i = e_i \sum_{j=0}^{i} s_j \qquad 0 < i < k,$$

$$d_i = e_i \qquad k < i < n$$

**3.** Circuit logique d'adressage (206) selon la revendication 1, dans lequel k est un nombre de précisions de la pluralité de nombres ayant une précision S avec

$$S = \sum_{i=0}^{k-1} e_i 2^i$$

où $s_i$ sont des signaux de coefficient binaire de précision, et ledit circuit logique d'extension génère les signaux de coefficient binaire d'adresse physique $d_i$ selon l'équation logique suivante :

$$d_i = e_{i-n} \sum_{j=i-n+1}^{k-1} s_j \qquad n \le i \le n + k - 2, i < m$$

**4.** Circuit logique d'adressage (206) selon la revendication 1, dans lequel lesdites positions en mémoire sont des registres de microprocesseur.

**5.** Procédé d'adressage de positions en mémoire dans un système informatique, possédant un processeur pour la manipulation d'une pluralités de nombres de précision S, S étant une puissance de 2, selon lequel les positions en mémoire sont spécifiées dans un champ d'adresse d'instruction par une adresse logique de n bits :

$$E = \sum_{i=0}^{n-1} e_i 2^i$$

où $e_i$ sont des signaux de coefficient binaire d'adresse logique, chaque nombre de précision S étant stocké dans un groupe de S positions en mémoire accédées par une adresse physique de m bits :

$$D = \sum_{i=0}^{m-1} d_i 2^i$$

où $d_i$ sont des signaux de coefficient binaire d'adresse physique, chaque position en mémoire étant prévue pour stocker un nombre de simple précision ;

ledit procédé étant caractérisé par les étapes suivantes :

a) la réception de signaux de coefficient binaire d'adresse logique ;

b) en réponse aux signaux de coefficient binaire d'adresse logique reçus, la génération des signaux de coefficient binaire d'adresse physique $d_i = 0$ pour $0 \le i \le (\log_2 S)-1$ ;

c) en réponse aux signaux de coefficient binaire d'adresse logique reçus, la génération des signaux de coefficient binaire d'adresse physique $d_i = e_i$ pour $\log_2 S \le i \le n-1$ ; et

d) en réponse aux signaux de coefficient binaire d'adresse logique reçus, la génération des signaux de coefficient binaire d'adresse physique $d_i = e_{i-n}$ pour $n \le i \le m-1$ .

6. Procédé selon la revendication 5, selon lequel k est un nombre de précisions de la pluralité de nombres de précision S,

$$S = \sum_{i=0}^{k-1} e_i 2^i$$

où $s_i$ sont des signaux de coefficient binaire de précision ;

l'étape b) est mise en oeuvre selon l'équation logique suivante :

$$d_i = e_i \sum_{j=0}^{i} s_j \qquad 0 < i < k,$$

et l'étape c) est mise en oeuvre selon l'équation logique suivante :

$$d_i = e_i \qquad k < i < n$$

7. Procédé selon la revendication 5, selon lequel k est un nombre de précisions de la pluralité de nombres de précision S,

$$S = \sum_{i=0}^{k-1} e_i 2^i$$

où $s_i$ sont des signaux de coefficient binaire de précision, et l'étape d) est mise en oeuvre selon l'équation logique suivante :

$$d_i = e_{i-n} \sum_{j=i-n+1}^{k-1} s_j \qquad n < i < n+k-2, i < m$$

8. Procédé selon la revendication 5, selon lequel lesdites positions en mémoire sont des registres de microprocesseur.

**9.** Processeur pour la manipulation d'une pluralité de nombres de précision S, S étant une puissance de 2, le processeur possédant une première pluralité de positions en mémoire adressables par une première pluralité d'adresses logiques E, chaque adresse logique de la première pluralité d'adresses logiques ayant la forme cS où c est choisi dans l'ensemble {0, 1, ..., ((r/S) -1)}, r est le nombre de positions en mémoire dans la première pluralité de positions de mémoire, chaque position en mémoire dans la première pluralité de positions en mémoire pouvant stocker un nombre de simple précision, les positions en mémoire de la première pluralité de positions en mémoire étant adressables par groupes de S, le processeur étant caractérisé, de plus, par :

- une pluralité de S-1 pluralités additionnelles de positions en mémoire, chaque position en mémoire de chaque pluralité additionnelle de positions en mémoire pouvant stocker un nombre de simple précision, les positions en mémoire dans chaque pluralité additionnelle de positions en mémoire étant adressables par groupes de S, r étant le nombre de positions en mémoire dans chaque pluralité additionnelle de positions en mémoire ; et

- un circuit logique d'adressage (206) pour adresser la pluralité de S-1 pluralités additionnelles de positions en mémoire utilisant une pluralité additionnelle associée d'adresses logiques pour chaque pluralité additionnelle de positions en mémoire, chaque adresse d'une i$^{ième}$ pluralité additionnelle associée d'adresses logiques prenant la forme de cS + i où i est choisi dans l'ensemble {1, 2, ..., S-1}, le circuit logique d'adressage (206) étant couplé aux pluralités additionnelles de registres.

**10.** Processeur selon la revendication 9, dans lequel les positions en mémoire sont spécifiées dans un champ d'adresse d'instruction par une adresse logique de n bits :

$$E = \sum_{i=0}^{n-1} e_i 2^i$$

où $e_i$ sont des signaux de coefficient binaire d'adresse logique, chaque nombre ayant une précision S étant accédé par une adresse physique de m bits :

$$D = \sum_{i=0}^{m-1} d_i 2^i$$

où $d_i$ sont des signaux de coefficient binaire d'adresse physique ;

ledit circuit logique d'adressage (206) comprenant

- un circuit logique d'alignement pour recevoir des signaux de coefficient binaire d'adresse logique et pour générer en réponse les signaux de coefficient binaire d'adresse physique $d_i = 0$ pour $0 \leq i \leq (\log_2 S)-1$ et $d_i = e_i$ pour $\log_2 S \leq i \leq n-1$ ; et

- un circuit logique d'extension pour recevoir des signaux de coefficient binaire d'adresse logique et pour générer en réponse les signaux de coefficient binaire d'adresse physique $d_i = e_{i-n}$ pour $n \leq i \leq m-1$ ;

dans lequel le circuit logique d'alignement et le circuit logique d'extension partagent P signaux de coefficient binaire d'adresse logique, P étant le nombre de cas pour lesquels i = j avec $\log_2 S \leq i \leq n-1$ et $0 \leq j \leq m-n-1$ .

**11.** Processeur selon la revendication 10, dans lequel k est un nombre de précisions de la pluralité de nombres ayant une précision S avec ,

$$S = \sum_{i=0}^{k-1} e_i 2^i$$

où $s_i$ sont des signaux de coefficient binaire de précision, et ledit circuit logique d'alignement génère les signaux de coefficient binaire d'adresse de précision $d_i$ selon les équations logiques suivantes :

$$d_i = e_i \sum_{j=0}^{i} s_j \qquad 0 < i < k,$$

**12.** Processeur selon la revendication 10, dans lequel k est un nombre de précisions de la pluralité de nombres ayant une précision S avec

$$S = \sum_{i=0}^{k-1} e_i 2^i$$

où $s_i$ sont des signaux de coefficient binaire de précision, et ledit circuit logique d'extension génère les signaux de coefficient binaire d'adresse de précision $d_i$ selon l'équation logique suivante :

$$d_i = e_{i-n} \sum_{j=i-n+1}^{k-1} s_j \qquad n \le i \le n + k - 2, i < m$$

**13.** Processeur selon la revendication 10, dans lequel lesdites positions en mémoire sont des registres de microprocesseur.

**Original**
**Registers S   D   Q**

| | S | D | Q |
|---|---|---|---|
| | 0 | 0 | 0 |
| | 1 | | |
| | 2 | 2 | |
| | 3 | | |
| | 4 | 4 | 4 |
| | 5 | | |
| | 6 | 6 | |
| | 7 | | |
| | 8 | 8 | 8 |
| | 9 | | |
| | 10 | 10 | |
| | 11 | | |
| | 12 | 12 | 12 |
| | 13 | | |
| | 14 | 14 | |
| | 15 | | |
| | 16 | 16 | 16 |
| | 17 | | |
| | 18 | 18 | |
| | 19 | | |
| | 20 | 20 | 20 |
| | 21 | | |
| | 22 | 22 | |
| | 23 | | |
| | 24 | 24 | 24 |
| | 25 | | |
| | 26 | 26 | |
| | 27 | | |
| | 28 | 28 | 28 |
| | 29 | | |
| | 30 | 30 | |
| | 31 | | |

# Fig. 1
*(Prior Art)*

| 31 - 30 | 29 - 25 | 24 - 19 | 18 - 14 | 13 - 7 | 6 - 5 | 4 - 0 |
|---|---|---|---|---|---|---|
| OPCODE ENCODING INFORMATION | DESTINATION REGISTER NUMBER | FLOATING POINT INDICATOR | SOURCE 2 REGISTER NUMBER | OPCODE | PRECISION | SOURCE 1 REGISTER NUMBER |

*Fig. 2*

*Fig. 3*

EP 0 640 912 B1

TO REGISTER FILE

$d_0 = e_0 s_0$
$d_1 = e_1(s_0 + s_1)$
$d_2 = e_2(s_0 + s_1 + s_2) = e_2$
$d_3 = e_3$
$d_4 = e_4$

*Fig. 4*

FROM INSTRUCTION DECODER

TO REGISTER FILE

*Fig. 7*

$d_0 = e_0 s_0$
$d_1 = e_0(s_0 + s_1)$
$d_2 = e_2$
$d_3 = e_3$
$d_4 = e_4$
$d_5 = e_0(s_1 + s_2)$
$d_6 = e_1 s_2$

| ORIGINAL REGISTERS | SINGLE | DOUBLE |
|---|---|---|
| | 0 | 0 |
| | 1 | |
| | 2 | 1 |
| | 3 | |
| | 4 | 2 |
| | 5 | |
| | 6 | 3 |
| | 7 | |
| | 8 | 4 |
| | 9 | |
| | 10 | 5 |
| | 11 | |
| | 12 | 6 |
| | 13 | |
| | 14 | 7 |
| | 15 | |
| | 16 | 8 |
| | 17 | |
| | 18 | 9 |
| | 19 | |
| | 20 | 10 |
| | 21 | |
| | 22 | 11 |
| | 23 | |
| | 24 | 12 |
| | 25 | |
| | 26 | 13 |
| | 27 | |
| | 28 | 14 |
| | 29 | |
| | 30 | 15 |
| | 31 | |

| ADDITIONAL REGISTERS | SINGLE | DOUBLE |
|---|---|---|
| | 32 | 16 |
| | 33 | |
| | 34 | 17 |
| | 35 | |
| | 36 | 18 |
| | 37 | |
| | 38 | 19 |
| | 39 | |
| | 40 | 20 |
| | 41 | |
| | 42 | 21 |
| | 43 | |
| | 44 | 22 |
| | 45 | |
| | 46 | 23 |
| | 47 | |
| | 48 | 24 |
| | 49 | |
| | 50 | 25 |
| | 51 | |
| | 52 | 26 |
| | 53 | |
| | 54 | 27 |
| | 55 | |
| | 56 | 28 |
| | 57 | |
| | 58 | 29 |
| | 59 | |
| | 60 | 30 |
| | 61 | |
| | 62 | 31 |
| | 63 | |

Fig. 5

**Original Registers**

| S | D | Q |
|---|---|---|
| 0 | 0 | 0 |
| 1 | | |
| 2 | 2 | |
| 3 | | |
| 4 | 4 | 4 |
| 5 | | |
| 6 | 6 | |
| 7 | | |
| 8 | 8 | 8 |
| 9 | | |
| 10 | 10 | |
| 11 | | |
| 12 | 12 | 12 |
| 13 | | |
| 14 | 14 | |
| 15 | | |
| 16 | 16 | 16 |
| 17 | | |
| 18 | 18 | |
| 19 | | |
| 20 | 20 | 20 |
| 21 | | |
| 22 | 22 | |
| 23 | | |
| 24 | 24 | 24 |
| 25 | | |
| 26 | 26 | |
| 27 | | |
| 28 | 28 | 28 |
| 29 | | |
| 30 | 30 | |
| 31 | | |

**Additional Registers "A"**

| | D | Q |
|---|---|---|
| 32 | 1 | 1 |
| 33 | | |
| 34 | 3 | |
| 35 | | |
| 36 | 5 | 5 |
| 37 | | |
| 38 | 7 | |
| 39 | | |
| 40 | 9 | 9 |
| 41 | | |
| 42 | 11 | |
| 43 | | |
| 44 | 13 | 13 |
| 45 | | |
| 46 | 15 | |
| 47 | | |
| 48 | 17 | 17 |
| 49 | | |
| 50 | 19 | |
| 51 | | |
| 52 | 21 | 21 |
| 53 | | |
| 54 | 23 | |
| 55 | | |
| 56 | 25 | 25 |
| 57 | | |
| 58 | 27 | |
| 59 | | |
| 60 | 29 | 29 |
| 61 | | |
| 62 | 31 | |
| 63 | | |

**Additional Registers "B"**

| | Q | | | Q |
|---|---|---|---|---|
| 64 | 2 | | 96 | 3 |
| 65 | | | 97 | |
| 66 | | | 98 | |
| 67 | | | 99 | |
| 68 | 6 | | 100 | 7 |
| 69 | | | 101 | |
| 70 | | | 102 | |
| 71 | | | 103 | |
| 72 | 10 | | 104 | 11 |
| 73 | | | 105 | |
| 74 | | | 106 | |
| 75 | | | 107 | |
| 76 | 14 | | 108 | 15 |
| 77 | | | 109 | |
| 78 | | | 110 | |
| 79 | | | 111 | |
| 80 | 18 | | 112 | 19 |
| 81 | | | 113 | |
| 82 | | | 114 | |
| 83 | | | 115 | |
| 84 | 22 | | 116 | 23 |
| 85 | | | 117 | |
| 86 | | | 118 | |
| 87 | | | 119 | |
| 88 | 26 | | 120 | 27 |
| 89 | | | 121 | |
| 90 | | | 122 | |
| 91 | | | 123 | |
| 92 | 30 | | 124 | 31 |
| 93 | | | 125 | |
| 94 | | | 126 | |
| 95 | | | 127 | |

*Fig. 6*

START

DECODE INSTRUCTION - OBTAIN
LOGICAL ADDRESS **E** AND
PRECISION **S**

SET $d_i = 0$ FOR
$0 \leq i \leq (\log_2 S) - 1$

SET $d_i = e_i$ FOR
$\log_2 S \leq i \leq n - 1$

SET $d_i = e_{i-n}$ FOR
$n \leq i \leq m - 1$

ADDRESS REGISTERS WITH
PHYSICAL ADDRESS **D**

STOP

*Fig. 8*